# EUROPÄISCHE PATENTSCHRIFT

(11) **EP 2 454 889 B1**
(45) Veröffentlichungstag und Bekanntmachung des Hinweises auf die Patenterteilung: **16.12.2015**
(21) Anmeldenummer: 10735248.6
(22) Anmeldetag: 16.07.2010
(51) Int. Cl.: H04R 1/10, G10K 11/175

(54) **HEADSET UND HÖRER**
HEADSET AND HEADPHONE
CASQUE D'ÉCOUTE ET ÉCOUTEUR

(30) Priorität: 17.07.2009 DE 202009009804 U
(43) Veröffentlichungstag der Anmeldung: 23.05.2012
(73) Patentinhaber: Sennheiser electronic GmbH & Co. KG, 30900 Wedemark (DE)
(72) Erfinder: KUHTZ, Jan Peter, 29221 Celle (DE); STREITENBERGER, Martin, 30163 Hannover (DE); GRANDT, André, 30900 Wedemark (DE); STEIN, Elmar, 31275 Lehrte (DE); FOUDHAILI, Hatem, 30161 Hannover (DE)
(74) Vertreter: Eisenführ Speiser
(86) Internationale Anmeldenummer: PCT/EP2010/060346
(87) Internationale Veröffentlichungsnummer: WO 2011/007000

(56) Entgegenhaltungen:
- WO-A1-2007/016020
- WO-A1-2008/095013
- WO-A1-2010/129241
- DE-U1-202009 001 941
- US-A1- 2005 201 585
- US-A1- 2007 160 223

## Beschreibung

Die vorliegende Erfindung betrifft ein Headset und einen Hörer.

Die modernen Headsets oder Hörer wie z. B. Kopfhörer weisen typischerweise eine aktive Lärmkompensation (active noise reduction ANR) auf, um den Betrieb bzw. die Benutzung der Headsets auch in lärmerfüllten Umgebungen wie beispielsweise einem Cockpit eines Flugzeugs zu ermöglichen bzw. zu verbessern. Die aktive Lärmkompensation kann hierbei sowohl analog als auch digital erfolgen.

Es ist eine Aufgabe der vorliegenden Erfindung, ein Headset und einen Hörer mit einer verbesserten aktiven Lärmkompensation vorzusehen.

Diese Aufgabe wird durch ein Headset gemäß Anspruch 1 und durch einen Hörer gemäß Anspruch 10 gelöst.

Somit wird ein Headset mit mindestens einem Mikrofon zum Erfassen von Umgebungsgeräuschen, mindestens einem elektroakustischen Wiedergabewandler und einer Steuereinheit zum Steuern des Headsets vorgesehen. Das Headset weist ferner eine digitale aktive Lärmkompensationseinheit zum Durchführen einer digitalen aktiven Lärmkompensation basierend auf den durch das Mikrofon aufgezeichneten Umgebungsgeräuschen auf. Das Headset weist ferner eine Datenschnittstelle zum Empfangen von Daten und/oder Parametern für das Headset und zum Ausgeben von in dem Headset gespeicherten Daten und/oder Parametern auf.

Gemäß einem Aspekt der vorliegenden Erfindung ist die Datenschnittstelle dazu ausgestaltet, eine Aktualisierung der Steuerung (Software-Update, Firmware-Update, Aktualisierung der Daten/Parameter) durchzuführen.

Gemäß einem weiteren Aspekt der vorliegenden Erfindung ist eine Drahtlos-Datenschnittstelle zum Senden und Empfangen von Daten und/oder Parametern von bzw. für das Headset vorgesehen.

Die Erfindung betrifft ebenfalls einen Hörer mit mindestens einem Mikrofon zum Erfassen von Umgebungsgeräuschen, mindestens einem elektroakustischen Wiedergabewandler zum Ausgeben eines wiederzugebenden Audiosignals und einer Steuereinheit zum Steuern des Hörers. Der Hörer weist ferner eine digitale aktive Lärmkompensationseinheit zum Durchführen einer aktiven Lärmkompensation basierend auf den durch das Mikrofon aufgezeichneten Umgebungsgeräuschen auf. Der Hörer weist ferner eine Datenschnittstelle zum Empfangen von Daten und/oder Parametern für den Hörer und zum Ausgeben von in dem Hörer gespeicherten Daten und/oder Parametern auf.

Die Erfindung betrifft den Gedanken, eine Schnittstelle an einem Headset/Hörer mit einer digitalen aktiven Lärmkompensationseinheit vorzusehen, über welche ein Update bzw. eine Aktualisierung der Firmware bzw. der Software der digitalen aktiven Lärmkompensationseinheit ermöglicht werden kann.

Somit können nachträgliche Verbesserungen der aktiven Lärmkompensation an die jeweiligen Headsets bzw. Hörer weitergegeben werden, damit die Steuerung der aktiven Lärmkompensationseinheiten aktualisiert bzw. angepasst werden kann. Ferner können durch die Schnittstelle Parameter sowohl für die aktive Lärmkompensation als auch für die Wiedergabe von Audiosignalen durch das Headset übermittelt und eingestellt werden.

Weitere Ausgestaltungen der Erfindung sind Gegenstand der Unteransprüche.

Vorteile und Ausführungsbeispiele der Erfindung werden nachstehend unter Bezugnahme auf die Zeichnung näher erläutert.
- Fig. 1: zeigt eine schematische Darstellung eines Headsets gemäß einem ersten Ausführungsbeispiel,
- Fig. 2: zeigt eine schematische Darstellung eines Headsets/Hörers gemäß einem zweiten Ausführungsbeispiel, und
- Fig. 3: zeigt eine schematische Darstellung eines Headsets/Hörers gemäß einem dritten Ausführungsbeispiel.

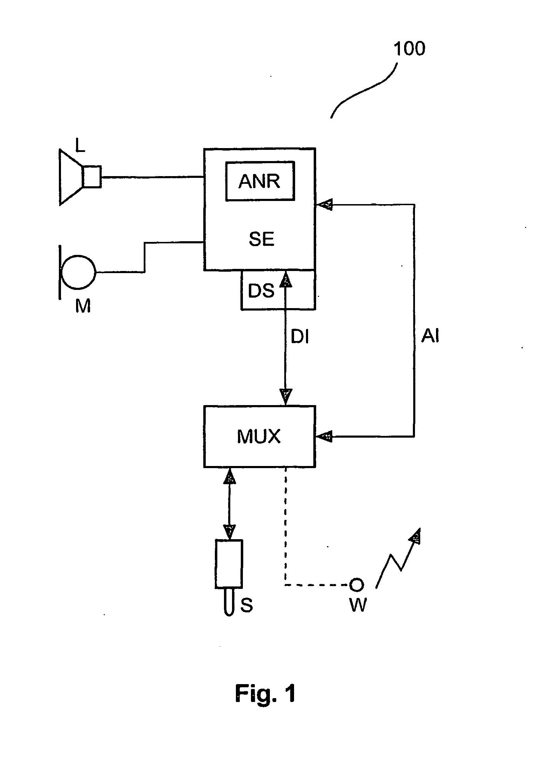

Fig. 1 zeigt eine schematische Darstellung eines Headsets gemäß einem ersten Ausführungsbeispiel. Das Headset 100 weist ein Mikrofon M und mindestens einen elektroakustischen Wiedergabewandler L auf. Das Headset weist ferner eine Steuereinheit SE mit einer digitalen aktiven Lärmkompensationseinheit ANR und eine Datenschnittstelle DS auf. Die digitale aktive Lärmkompensationseinheit ANR führt eine aktive Lärmkompensation basierend auf den durch das Mikrofon M aufgezeichneten Umgebungsgeräuschen durch und gibt ein Kompensationssignal an den elektroakustischen Wiedergabewandler L aus, welcher das wiederzugebende Audiosignal zusammen mit dem Kompensationssignal ausgibt. Das Headset weist optional ferner eine Multiplexereinheit MUX auf, welche über ein Kabel mit einem Stecker S zum Empfangen von wiederzugebenden Audiosignalen und zum Ausgeben von durch ein Mikrofon des Headsets aufgezeichneten Sprachsignalen verbunden ist. Optional kann die Multiplexereinheit MUX mit einem Drahtlossender/Empfänger W verbunden sein, um Daten und/oder Parameter drahtlos austauschen zu können. Die Multiplexereinheit MUX ist dazu in der Lage, sowohl Audiosignale von dem Stecker S als auch Datensignale von dem Stecker und/oder der Drahtlossen- de/Empfangseinheit zu empfangen. Ferner ist die Multiplexereinheit MUX dazu in der Lage, sowohl die Audiosignale AI an die Steuereinheit SE als auch die Datensignale DI an die Datenschnittstelle DS weiterzuleiten. Die Audiosignale AI stellen die durch das Headset wiederzugebenden Audiosignale dar. Die Datensignale DI können beispielsweise Update-Informationen, Einstellparameter oder dergleichen aufweisen. Ferner kann mittels der Datensignale DI ein Update der Steuerung der Steuereinheit SE durchgeführt werden. Diese Signale für das Update können sowohl über den Stecker als auch über die Drahtlossende/Empfangseinheit W empfangen werden.

Wie oben beschrieben, kann die Multiplexereinheit MUX mit einer (weiteren) Schnittstelle verbunden sein, welche als eine Drahtlosschnittstelle ausgestaltet ist. Alternativ bzw. zusätzlich dazu kann ebenfalls eine drahtgebundene Schnittstelle implementiert werden. Eine derartige Schnittstelle kann beispielsweise auf einem USB-, einem Firewire oder anderen Protokollen beruhen. Diese Schnittstelle kann ebenfalls durch den Audiostecker S implementiert werden.

Bei der Übertragung von Datensignalen können Einstellparameter des Headsets (Kompensationsfaktor, Rechts/Links-Abgleich, eine kundenspezifische Hörkurve und Kopfposition) übertragen werden. Ferner kann ein Firmware- bzw. ein Software-Update durchgeführt werden. Des Weiteren kann eine Remote-Funktionalität implementiert werden.

Optional können die in dem Headset gespeicherten Parameter, beispielsweise der aktiven Lärmkompensation, ausgelesen und an andere mobile Geräte wie beispielsweise Headsets oder Hörer wiedergegeben werden, damit diese Headsets bzw. Hörer ebenfalls durch die entsprechenden Einschaltparameter eingestellt werden. Der Austausch mit anderen mobilen Geräten kann drahtgebunden oder drahtlos beispielsweise via Bluetooth, WLAN etc. erfolgen. Die Daten des Headsets bzw. die Einstellparameter können zu Servicezwecken extrahiert und verarbeitet werden.

Mit dem erfindungsgemäßen Headset bzw. dem erfindungsgemäßen Hörer kann ein nachträgliches Update der Steuerung der Steuereinheit, insbesondere der aktiven Lärmkompensation, durchgeführt werden. Dadurch, dass die Einstellparameter extrahiert werden können, können sie durch Servicepersonal überprüft werden. Schließlich können die Einstellparameter oder andere Daten an weitere Geräte übertragen werden.

Gemäß einem weiteren Ausführungsbeispiel wird ein Hörer, beispielsweise ein Kopfhörer, vorgesehen. Der Kopfhörer gemäß dem weiteren Ausführungsbeispiel entspricht im Wesentlichen dem Headset gemäß dem ersten Ausführungsbeispiel. Somit wird ein Hörer mit einer Schnittstelle zum Austauschen von Daten und/oder Parametern des Hörers vorgesehen, um ein Update der Firmware, der Software oder der Parameter zu ermöglichen.

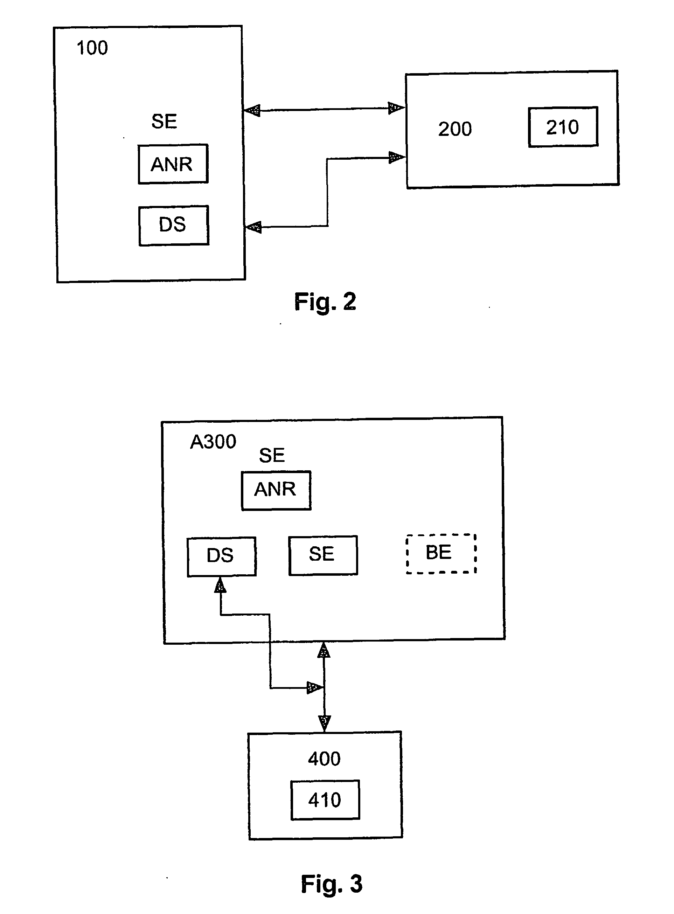

Fig. 2 zeigt eine schematische Darstellung eines Headsets/Hörers gemäß einem zweiten Ausführungsbeispiel. Das Headset/der Hörer 100 weist eine Steuereinheit SE mit einer aktiven Lärmkompensationseinheit ANR und eine digitale Schnittstelle DS auf. Das Headset/der Hörer 100 können mit einem Mediaplayer 200 gekoppelt werden. Der Mediaplayer kann zur Wiedergabe von Audiosignalen verwendet werden, die dann durch das Headset bzw. den Hörer wiedergegeben werden können. Zusätzlich zu den Audiosignalen kann der Mediaplayer Datensignale DI wie beispielsweise Update-Informationen, Einstellparameter oder dergleichen übertragen.

Der Mediaplayer 200 kann eine Parameter-Einstelleinheit 210 aufweisen, mittels welcher die Parameter der Steuereinheit SE und/oder der aktiven Lärmkompensationseinheit ANR eingestellt werden können.

Fig. 3 zeigt eine schematische Darstellung eines Headsets/Hörers gemäß einem dritten Ausführungsbeispiel. Das Headset 300 bzw. der Hörer 300 weist eine Steuereinheit SE mit einer aktiven Lärmkompensationseinheit ANR, eine Datenschnittstelle DS, eine Drahtlos-Sende-/Empfangseinheit SE sowie optional eine Batterieeinheit BE auf. Der Hörer bzw. das Headset 300 können mit einem Mediaplayer 400 gekoppelt werden.

Hierbei kann die Kopplung drahtlos erfolgen, d. h. der Mediaplayer 400 kann Audiosignale drahtlos an den Hörer bzw. das Headset übertragen. Dazu kann der Mediaplayer 400 eine Drahtlos-Sende/Empfangseinheit aufweisen. Der Mediaplayer weist ferner eine Parameter-Einstelleinheit 410 zum Einstellen der Parameter der Steuereinheit SE und/oder der aktiven Lärmkompensationseinheit ANR auf.

Die drahtlose Übertragungsstrecke zwischen dem Mediaplayer 400 und dem Headset bzw. dem Hörer 300 kann zur Übertragung der Audiosignale sowie zur Übertragung von Datensignalen DI verwendet werden.

Die Parametereinstelleinheit 210, 410 gemäß dem zweiten oder dritten Ausführungsbeispiel kann auch als ein Software-Modul implementiert werden. Mittels der Parametereinstelleinheit 210, 410 können die Parameter der Steuereinheit SE bzw. die Parameter der aktiven Lärmkompensationseinheit ANR eingestellt werden. Somit lässt sich eine personifizierte Einstellung ermöglichen.

Die aktive Lärmkompensationseinheit gemäß dem ersten, zweiten oder dritten Ausführungsbeispiel ist optional digital realisiert. Da eine digital implementierte aktive Lärmkompensation spezielle Anforderungen an die digitale Hardware stellt, wird die digitale Hardware für die aktive Lärmkompensation in dem Headset bzw. Hörer implementiert.

Die Datenschnittstelle DS gemäß dem ersten, zweiten oder dritten Ausführungsbeispiel dient einem Firmware-Update und einer uni- oder bidirektionalen Datenkommunikation zusätzlich zu der Übertragung von Audiosignalen, um die Parameter der Steuereinheit bzw. der aktiven Lärmkompensationseinheit einzustellen. Ferner kann die Datenschnittstelle dazu verwendet werden, dass ein Benutzer die Funktionalität der aktiven Lärmkompensationseinheit einstellt. Hierzu können verschiedene Modi ausgewählt werden, die Adaption der Lärmkompensation kann gesteuert werden, und verschiedene Profile können gespeichert werden. Alternativ bzw. zusätzlich dazu kann der Frequenzgang gemessen werden, Audio- bzw. Lärmpegel können bestimmt werden, und Klangprofile können bestimmt und gespeichert werden. Ferner kann die Datenschnittstelle zur Test- und Prüffunktion während der Produktion verwendet werden.

Als Datenschnittstelle kann beispielsweise eine USB-Schnittstelle oder ein anderer digitaler Port des Mediaplayers verwendet werden.

Optional kann die Parameter-Einstelleinheit 210, 410 als ein Software-Modul realisiert werden, welches beispielsweise von einem externen Server (beispielsweise iTunes) herunter geladen und in dem Mediaplayer installiert werden kann.

Wenn eine drahtgebundene Verbindung zwischen dem Mediaplayer und dem Headset bzw. Hörer vorhanden ist, dann kann der Mediaplayer die Stromversorgung für das Headset bzw. den Hörer zur Verfügung stellen.

Zusätzlich bzw. alternativ dazu kann in dem Headset bzw. dem Hörer bzw. am Kabel ein optionales Batteriefach vorgesehen werden. Durch dieses Batteriefach (mit den darin befindlichen Batterien bzw. Akkus) kann die Stromversorgung für das Headset bzw. den Hörer realisiert werden.

Optional kann die Datenschnittstelle und die Audioschnittstelle in einer Schnittstelle wie beispielsweise eine USB-Schnittstelle realisiert werden. Bei einer drahtlosen Verbindung kann die Schnittstelle beispielsweise basierend auf einem Bluetooth-Protokoll oder einem WiFi-Protokoll realisiert werden.

Gemäß der Erfindung können die Parameter und Einstellungen an der Steuereinheit SE und der aktiven Lärmkompensationseinheit ANR über den Mediaplayer bzw. der darin vorgesehenen Parameter-Einstelleinheit vorgenommen werden.

Falls gemäß dem ersten, zweiten oder dritten Ausführungsbeispiel keine Stromversorgung für die aktive Lärmkompensationseinheit ANR vorhanden ist, dann kann die aktive Lärmkompensationseinheit deaktiviert werden, so dass nach wie vor eine Audiowiedergabe über das Headset bzw. den Hörer möglich ist.

Gemäß einem vierten Ausführungsbeispiel, welches auf dem ersten, zweiten oder dritten Ausführungsbeispiel basieren kann, wird ein optionales Batteriefach für das Headset bzw. den Hörer vorgesehen. Dieses Batteriefach kann als ein externes Gerät oder als ein Clip-on Batteriefach ausgestaltet sein. Hierbei kann eine Grundfunktionalität des Hörers, nämlich eine Audiowiedergabe, realisiert werden, auch wenn keine Spannungsversorgung vorhanden ist. Eine erweiterte Funktionalität kann ermöglich werden, wenn eine Spannungsversorgung für die aktive Lärmkompensationseinheit ANR vorhanden ist. Ferner können die Parameter der aktiven Lärmkompensationseinheit beispielsweise mittels eines Mediaplayers sowie der darin vorgesehenen Parameter-Einstelleinheit eingestellt werden. Eine Kommunikation zwischen dem Hörer bzw. dem Headset und dem Mediaplayer kann hierbei drahtlos oder drahtgebunden erfolgen.

Gemäß einem weiteren Aspekt der vorliegenden Erfindung kann ein Hörer bzw. ein Headset über ein Standardkabel mit einem Mediaplayer gekoppelt werden. Hierbei dient dann der Hörer bzw. das Headset der Audiowiedergabe. Wenn ein Clip-on Batteriefach vorgesehen ist, dann kann der Hörer bzw. das Headset zur aktiven Lärmkompensation verwendet werden. Der Hörer bzw. das Headset kann ferner optional drahtlos mit einem Audiosignal versorgt werden, welches dann wiederzugeben ist. Auf dem Mediaplayer kann eine Parameter-Einstelleinheit vorgesehen sein, welche beispielsweise als ein Softwaremodul realisiert wird. Mittels dieser Einheit können dann die Parameter bzw. die Einstellungen der aktiven Lärmkompensation vorgenommen werden.

## Patentansprüche

1. Headset, mit
mindestens einem Mikrofon (M) zum Erfassen von Umgebungsgeräuschen, mindestens einem elektroakustischen Wiedergabewandler (L) zum Ausgeben eines wiederzugebenden Audiosignals,
einer Steuereinheit (SE) zum Steuern des Headsets,
einer digitalen aktiven Lärmkompensationseinheit (ANR) mit ersten einstellbaren Parametern und einer einstellbaren Funktionalität zum Durchführen einer aktiven Lärmkompensation basierend auf den durch das Mikrofon (M) aufgezeichneten Umgebungsgeräuschen, den ersten eingestellten Parametern und der eingestellten Funktionalität, und
einer Datenschnittstelle (DS) zum Empfangen von Funktionalitätseinstellungen und ersten Parametern für die Lärmkompensationseinheit (ANR), zum Ausgeben von in dem Headset gespeicherten Daten und/oder ersten Parametern und zum Koppeln des Headsets (100) über eine bidirektionale Datenkommunikation mit einem externen Mediaplayer (200, 400), und
wobei die aktive Lärmkompensationseinheit (ANR) entsprechend der empfangenen ersten Parameter und Funktionalitätseinstellungen eingestellt wird.

2. Headset nach Anspruch 1, ferner mit
einer Multiplexereinheit (MUX), welche dazu ausgestaltet ist, sowohl Audiosignale (AI) an die Steuereinheit (SE) als auch Datensignale (DI) an die Schnittstelle (DS) weiterzuleiten.

3. Headset nach Anspruch 1, wobei
die Steuereinheit (SE) zweite einstellbare Parameter aufweist.

4. Headset nach Anspruch 3, wobei
die ersten und zweiten Parameter eine personfizierte Einstellung ermöglichen.

5. Headset nach Anspruch 1, ferner mit
einem Batteriefach, welches zur Aufnahme von Batterien oder Akkus zur Stromversorgung für das Headset dient.

6. Headset nach Anspruch 1, wobei
die Lärmkompensationseinheit (ANR) deaktiviert werden kann, falls keine Stromversorgung für die Lärmkompensationseinheit (ANR) vorhanden ist, sodass nach wie vor eine Audiowiedergabe über das Headset (100) möglich ist.

7. Headset nach Anspruch 1, wobei
die Funktionalitätseinstellungen verschiedene Modi der Lärmkompensation, eine Adaption der Lärmkompensation und/oder verschiedene Profile für die Lärmkompensation aufweisen.

8. Headset nach Anspruch 1 oder 7, wobei
die Datenschnittstelle (DS) dazu ausgestaltet ist, eine Aktualisierung der Steuerung der Steuereinheit (SE) durchzuführen.

9. Headset nach Anspruch 1, 7 oder 8, ferner mit einer Drahtlos-Datenschnittstelle (DS) zum Senden und Empfangen von Daten und/oder Parametern von bzw. für das Headset.

10. Hörer, mit
mindestens einem Mikrofon (M) zum Erfassen von Umgebungsgeräuschen,
mindestens einem elektroakustischen Wiedergabewandler (L) zum Ausgeben eines wiederzugebenden Audiosignals,
einer Steuereinheit (SE) zum Steuern des Hörers,
einer digitalen aktiven Lärmkompensationseinheit (ANR) mit ersten einstellbaren Parametern und einer einstellbaren Funktionalität zum Durchführen einer aktiven Lärmkompensation basierend auf den durch das Mikrofon (M) aufgezeichneten Umgebungsgeräuschen und den ersten eingestellten Parametern und der eingestellten Funktionalität, und
einer Datenschnittstelle (DS) zum Empfangen von Funktionalitätseinstellungen und ersten Parametern für die aktive Lärmkompensationseinheit, zum Ausgeben von in dem Hörer gespeicherten Daten und/oder ersten Parametern und zum Koppeln des örers (100) über eine bidirektionale Datenkommunikation mit einem externen Mediaplayer (200, 400),
wobei die aktive Lärmkompensationseinheit entsprechend der empfangenen Parameter und Funktionalitätseinstellungen eingestellt wird.

11. System, mit
einem Headset nach einem der Ansprüche 1 bis 9 oder
einem Hörer nach Anspruch 10, und
einem mit dem Headset gekoppelten Mediaplayer (200, 400), der eine Parameter-Einstelleinheit (410) zum Einstellen der Parameter der Steuereinheit SE und/oder der aktiven Lärmkompensationseinheit (ANR) aufweist.

## Claims

1. Headset having
at least one microphone (M) for detecting ambient noises,
at least one electroacoustic playback transducer (L) for outputting an audio signal which is intended to be reproduced, a control unit (SE) for controlling the headset,
a digital active noise compensation unit (ANR) having first adjustable parameters and an adjustable functionality for carrying out active noise compensation based on the ambient noises recorded by the microphone (M), the first adjusted parameters and the adjusted functionality, and
a data interface (DS) for receiving functionality adjustments and first parameters for the noise compensation unit (ANR), for outputting data stored in the headset and/or first parameters and for coupling the headset (100) by means of a bidirectional data communication to an external media player (200, 400), and
wherein the active noise compensation unit (ANR) is adjusted in accordance with the first parameters received and functionality adjustments.

2. Headset according to claim 1, further having
a multiplexer unit (MUX) which is configured to forward both audio signals (AI) to the control until (SE) and data signals (DI) to the interface (DS).

3. Headset according to claim 1, wherein
the control unit (SE) has second adjustable parameters.

4. Headset according to claim 3, wherein
the first and second parameters enable a personalised adjustment.

5. Headset according to claim 1, further having
a battery compartment which serves to receive batteries or accumulators for power supply for the headset.

6. Headset according to claim 1, wherein
the noise compensation unit (ANR) can be deactivated if there is no power supply for the noise compensation unit (ANR) so that an audio reproduction via the headset (100) is still possible.

7. Headset according to claim 1, wherein
the functionality adjustments have different modes of the noise compensation, an adaptation of the noise compensation and/or different profiles for the noise compensation.

8. Headset according to claim 1 or claim 7, wherein
the data interface (DS) is configured to carry out an updating of the control of the control unit (SE).

9. Headset according to claim 1, 7 or 8, further having a wireless data interface (DS) for transmitting and receiving data and/or parameters from or for the headset.

10. Headphone having
at least one microphone (M) for detecting ambient noises,
at least one electroacoustic playback transducer (L) for outputting an audio signal which is intended to be reproduced, a control unit (SE) for controlling the headphone,
a digital active noise compensation unit (ANR) having first adjustable parameters and an adjustable functionality for carrying out active noise compensation based on the ambient noises recorded by the microphone (M) and the first adjusted parameters and the adjusted functionality, and
a data interface (DS) for receiving functionality adjustments and first parameters for the active noise compensation unit, for outputting data stored in the headphone and/or first parameters and for coupling the headphone (100) by means of a bidirectional data communication to an external media player (200, 400),
wherein the active noise compensation unit is adjusted in accordance with the parameters received and functionality adjustments.

11. System having
a headset according to any one of claims 1 to 9, or
a headphone according to claim 10, and
a media player (200, 400) which is coupled to the headset and which has a parameter adjustment unit (410) for adjusting the parameters of the control unit SE and/or the active noise compensation unit (ANR).

## Revendications

1. Casque d'écoute, comprenant
au moins un microphone (M) servant à détecter des bruits environnants,
au moins un transducteur de reproduction électroacoustique (L) servant à délivrer un signal audio à reproduire,
une unité de commande (SE) servant à commander le casque d'écoute,
une unité de compensation de bruit active numérique (ANR) présentant des premiers paramètres réglables et une fonctionnalité réglable servant à mettre en oeuvre une compensation de bruit active sur la base des bruits environnants enregistrés par le microphone (M), sur la base des premiers paramètres réglés et de la fonctionnalité réglée, et
une interface de données (DS) servant à recevoir des réglages de fonctionnalité et des premiers paramètres pour l'unité de compensation de bruit (ANR), servant à délivrer des données mémorisées dans le casque d'écoute et/ou des premiers paramètres et servant à coupler le casque d'écoute (100) à un lecteur média externe (200, 400) par l'intermédiaire d'une communication de données bidirectionnelle, et
dans lequel l'unité de compensation de bruit active (ANR) est réglée conformément aux premiers paramètres reçus et aux réglages de fonctionnalité.

2. Casque d'écoute selon la revendication 1, comprenant en outre
une unité de multiplexage (MUX), qui est configurée pour transférer aussi bien des signaux audio (AI) à l'unité de commande (SE) que des signaux de données (DI) à l'interface (DS).

3. Casque d'écoute selon la revendication 1,
dans lequel
l'unité de commande (SE) présente des deuxièmes paramètres réglables.

4. Casque d'écoute selon la revendication 3,
dans lequel
les premiers et les deuxièmes paramètres permettent un réglage personnalisé.

5. Casque d'écoute selon la revendication 1, comprenant en outre
un compartiment à piles, qui sert à recevoir des piles ou des accus pour l'alimentation électrique du casque d'écoute.

6. Casque d'écoute selon la revendication 1,
dans lequel
l'unité de compensation de bruit (ANR) peut être désactivée en l'absence de toute alimentation électrique de l'unité de compensation de bruit (ANR) si bien qu'une reproduction audio par l'intermédiaire du casque d'écoute (100) reste possible.

7. Casque d'écoute selon la revendication 1,
dans lequel
les réglages de fonctionnalité présentent plusieurs modes de compensation de bruit, une adaptation de la compensation de bruit et/ou différents profils de compensation de bruit.

8. Casque d'écoute selon la revendication 1 ou 7, dans lequel
l'interface de données (DS) est configurée pour mettre en oeuvre une mise à jour de la commande de l'unité de commande (SE).

9. Casque d'écoute selon la revendication 1, 7 ou 8, comprenant en outre une interface de données sans fil (DS) pour envoyer et recevoir des données et/ou des paramètres de ou pour le casque d'écoute.

10. Ecouteur, comprenant
au moins un microphone (M) servant à détecter des bruits environnants,
au moins un transducteur de reproduction électroacoustique (L) servant à délivrer un signal audio à reproduire,
une unité de commande (SE) servant à commander l'écouteur,
une unité de compensation de bruit active numérique (ANR) présentant des premiers paramètres réglables et une fonctionnalité réglable pour mettre en oeuvre une compensation de bruit active sur la base des bruits environnants enregistrés par le microphone (M) et sur la base des premiers paramètres réglés et de la fonctionnalité réglée, et
une interface de données (DS) pour recevoir des réglages de fonctionnalité et des premiers paramètres pour l'unité de compensation de bruit active, servant à délivrer des données mémorisées dans l'écouteur et/ou des premiers paramètres et pour coupler l'écouteur (100) à un lecteur média (200, 400) externe par l'intermédiaire d'une communication de données bidirectionnelle,
dans lequel l'unité de compensation de bruit active est réglée conformément aux paramètres et aux réglages de fonctionnalité reçus.

11. Système comprenant
un casque d'écoute selon l'une quelconque des revendications 1 à 9 ou
un écouteur selon la revendication 10, et
un lecteur média (200, 400) couplé au casque d'écoute, lequel comprend une unité de réglage de paramètre (410) pour régler les paramètres de l'unité de commande (SE) et/ou de l'unité de compensation de bruit active (ANR).
